(19) **Europäisches Patentamt**
**European Patent Office**
**Office européen des brevets**

(11) **EP 3 064 603 B1**

(12) **EUROPEAN PATENT SPECIFICATION**

(45) Date of publication and mention
of the grant of the patent:
**28.11.2018 Bulletin 2018/48**

(51) Int Cl.:
*C22C 5/06* $^{(2006.01)}$    *C23C 14/16* $^{(2006.01)}$
*C23C 14/34* $^{(2006.01)}$    *H01B 1/02* $^{(2006.01)}$
*H01B 5/02* $^{(2006.01)}$

(21) Application number: **15776508.2**

(22) Date of filing: **18.03.2015**

(86) International application number:
**PCT/JP2015/058051**

(87) International publication number:
**WO 2015/156093 (15.10.2015 Gazette 2015/41)**

(54) **SILVER ALLOY FILM, AND SPUTTERING TARGET FOR FORMING SILVER ALLOY FILM**

SILBERLEGIERUNGSFILM UND SPUTTERTARGET ZUR BILDUNG DES
SILBERLEGIERUNGSFILMS

FILM D'ALLIAGE D'ARGENT ET CIBLE DE PULVÉRISATION CATHODIQUE POUR LA FORMATION
D'UN FILM D'ALLIAGE D'ARGENT

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **09.04.2014 JP 2014080354**

(43) Date of publication of application:
**07.09.2016 Bulletin 2016/36**

(60) Divisional application:
**18186524.7**

(73) Proprietor: **Mitsubishi Materials Corporation**
**Chiyoda-ku**
**Tokyo 100-8117 (JP)**

(72) Inventors:
• **NONAKA Sohei**
**Sanda-shi**
**Hyogo 669-1339 (JP)**

• **KOMIYAMA Shozo**
**Sanda-shi**
**Hyogo 669-1339 (JP)**
• **TOSHIMORI Yuto**
**Sanda-shi**
**Hyogo 669-1339 (JP)**

(74) Representative: **Hoffmann Eitle**
**Patent- und Rechtsanwälte PartmbB**
**Arabellastraße 30**
**81925 München (DE)**

(56) References cited:
WO-A1-03/100112    WO-A1-2015/008540
JP-A- 2005 100 604    JP-A- 2005 100 604
JP-A- 2012 219 305    JP-A- 2013 165 053
JP-A- 2013 165 053    JP-A- 2014 019 932

**Description**

TECHNICAL FIELD

The present invention relates to a Ag alloy film used as a reflective electrode film for a display, an LED or the like, as a wiring film for a touch panel or the like, as a transparent conductive film, and the like; and to a sputtering target for forming a Ag alloy film used to form the Ag alloy film.

The present application claims priority on Japanese Patent Application No. 2014-080354 filed on April 9, 2014.

BACKGROUND ART

In general, as a reflective electrode film for a display, an LED or the like, as a wiring film for a touch panel or the like, as a transparent conductive film, and the like; a Ag film having a low resistivity is used. For example, Patent Document 1 discloses a Ag film or a Ag alloy film which reflects light with high efficiency and is used as a constituent material of an electrode of a semiconductor light emitting element. In addition, Patent Document 2 discloses a Ag alloy used as a constituent material of a reflective electrode of an organic LED (OLED). Further, Patent Document 3 discloses a Ag alloy film used as a lead-out wiring of a touch panel. These Ag films and Ag alloy films are formed by sputtering a sputtering target made of Ag or a Ag alloy.

In recent years, in the process of producing a wiring for an organic LED (OLED), a touch panel, or the like, the size (area) of a glass substrate has been increased. Accordingly, the size of a sputtering target used in the case where a film is formed on a substrate having a large area has also been increased. Here, in the case where sputtering is carried out by applying high electric power to a large sputtering target, there is a concern that a phenomenon called "splash" may occur due to abnormal discharge of the target. In the case where the splash phenomenon occurs, melted fine particles adhere to the substrate, which causes a short circuit between wirings and electrodes; and thereby, a problem may be caused in which the yield greatly decreases.

Here, for example, Patent Document 4 proposes a large sputtering target in which the occurrence of "splash" is suppressed by specifying a Ag alloy composition.

However, in recent years, in a display, an LED, a touch panel, an organic LED (OLED), and the like, a fine electrode pattern and a fine wiring pattern have been achieved. Here, since a migration phenomenon easily occurs in a Ag film, there is a concern that a short circuit may occur in the fine electrode pattern and the fine wiring pattern. Therefore, there has been a demand for a Ag alloy film having particularly excellent migration resistance.

In addition, in the case where a Ag alloy film is formed on a substrate having a large area by using a large sputtering target, it is required that constituent elements contained in the Ag alloy be uniformly distributed so that variations in the in-plane properties of the Ag alloy film do not occur.

On the other hand, Ag easily reacts with sulfur. Sulfur components are contained in chemical agents used in a process of producing a display panel or the like, such as, for example, in a process of coating or stripping a photoresist for patterning, and in the atmosphere of the production process and the environment. Ag is sulfurized by these sulfur components and thus the properties may be deteriorated or the yield may be decreased. Accordingly, a Ag alloy film used as an electrode and wiring is required to have sulfidation resistance.

Patent Document 5 describes a conductive film, a method of manufacturing the same and a sputtering target used therefor. The conductive film contains 0.1 to 1.5 atom% of at least one of In and Sn, further contains 0.1 to 3.5 atom% of Sb, and the remaining part is constituted of a silver alloy having component compositions composed of Ag and inevitable impurities.

Patent Document 6 describes an Ag alloy film and a method of manufacturing the same. The Ag alloy film includes an Ag-In alloy layer having a component composition containing In of 0.1-1.8 atom% and the remainder of Ag and inevitable impurities and an In oxide layer formed on the surface of the Ag-In alloy layer and having a thickness of 10 nm or less, and has a surface roughness Ra of 1 nm or less and a specific resistance of $3.0 \times 10^{-6}$ $\Omega$ cm or less. The method of manufacturing the Ag alloy film comprises the steps of: forming a film at a temperature of 150°C or less by sputtering using a sputtering target formed of Ag-In alloy having a component composition consisting of In of 0.1-1.8 atom% and the remainder of Ag and inevitable impurities; and heat-treating the formed film at a temperature of 200-300°C in an inert gas atmosphere.

Patent Document 7 describes a reflective film of an optical recording medium and a silver alloy sputtering target for forming the reflective film. The silver alloy reflective film comprises an Ag alloy including 0.1-2.0 mass% of In, and in addition, (A) an Ag alloy of a composition including 0.005-0.1 mass% of Ca, (B) an Ag alloy of a composition including 0.005-0.1 mass% in total of one kind or two or more kinds selected from W, Ta, Mo, Nb, V, and Zr, (C) an Ag alloy of a composition including 0.05-1.0 mass% in total of one kind or two kinds or more selected from Tb, Gd, Dy, Nd, Ce, La, Pr, and Y, or (D) an Ag alloy of a composition including 0.1-1.0 mass% in total of one kind or two kinds selected from Au, Pd, Pt, Cu, Mn, Sb, Mg, Bi, Ga, Ge, and Sn.

PRIOR ART DOCUMENTS

Patent Documents

Patent Document 1: Japanese Unexamined Patent Application, First Publication No. 2006-245230
Patent Document 2: Japanese Unexamined Patent Application, First Publication No. 2012-059576
Patent Document 3: Japanese Unexamined Patent Application, First Publication No. 2009-031705
Patent Document 4: Japanese Unexamined Patent Application, First Publication No. 2013-216976
Patent Document 5: JP 2013-165053 A
Patent Document 6: JP 2014-019932 A
Patent Document 7: JP 2015-100604 A

DISCLOSURE OF THE INVENTION

Problems to be Solved by the Invention

The present invention has been made in consideration of the above circumstances and an object thereof is to provide a Ag alloy film excellent in migration resistance and sulfidation resistance, and a sputtering target for forming a Ag alloy film which can form a Ag alloy film exhibiting stable in-plane properties even in the case where the film is formed on a substrate having a large area.

Means for Solving the Problem

In order to solve the above problems, a Ag alloy film according to an aspect of the present invention has a composition including: In: 0.1% by mass to 1.5% by mass; and Cu: 1 ppm by mass to 50 ppm by mass; Ca: 0.5 ppm by mass to 20 ppm by mass; and optionally Sb: 0.01 % by mass to 1.0 % by mass, with the remainder being Ag and inevitable impurities.

Since the Ag alloy film having these features according to the aspect of the present invention includes 1 ppm by mass to 50 ppm by mass of Cu, the occurrence of a Ag ion migration phenomenon can be suppressed and the migration resistance can be greatly improved.

In addition, since the Ag alloy film includes 0.1% by mass to 1.5% by mass of In, it is possible to improve the sulfidation resistance of the film. Accordingly, the deterioration of the properties can be suppressed during the production process and in the environment.

Herein, it is preferable that the Ag alloy film according to the aspect of the present invention further includes Sb: 0.01% by mass to 1.0% by mass.

With regard to the above-mentioned display and LED, a heat treatment at a high temperature is carried out during the production process thereof. Therefore, the Ag alloy film used as the electrode and the wiring of the display and the LED is required to have heat resistance such that properties do not deteriorate after the heat treatment. By further including 0.01% by mass to 1.0% by mass of Sb in the Ag alloy film according to the aspect of the present invention, the heat resistance of the film is improved and the deterioration of the properties after the heat treatment can be suppressed. Accordingly, this Ag alloy film is particularly suitable for a Ag alloy film used as the electrode and the wiring of the display and the LED.

The Ag alloy film according to the aspect of the present invention further includes Ca: 0.5 ppm by mass to 20 ppm by mass.

In this case, since the Ag alloy film includes 0.5 ppm by mass to 20 ppm by mass of Ca, the occurrence of a Ag ion migration phenomenon can be reliably suppressed by the interaction with Cu, and the migration resistance can be greatly improved.

A planar and rectangular or cylindrical sputtering target for forming the Ag alloy film according to an aspect of the present invention has a composition including: In: 0.1% by mass to 1.5% by mass; Cu: 1 ppm by mass to 50 ppm by mass; Ca: 0.5 ppm by mass to 20 ppm by mass; and optionally Sb: 0.1 % by mass to 3.5 % by mass, with the remainder being Ag and inevitable impurities, wherein an oxygen concentration is less than 50 ppm by mass, an area of a sputtering surface is 0.25 $m^2$ or more, and an in-plane Cu concentration distribution $D_{Cu}$ defined by Expression (1) below is 40% or less:

$$D_{Cu} = (\sigma_{Cu}/\mu_{Cu}) \times 100 \, [\%] \qquad (1)$$

wherein, in Expression (1), $\mu_{Cu}$ represents an average value of Cu concentration analysis values obtained by analyzing Cu concentrations at five of points on the sputtering surface, and $\sigma_{Cu}$ represents a standard deviation of the Cu concentration analysis values.

Since the sputtering target for forming a Ag alloy film having these features according to the aspect of the present invention includes: 0.1% by mass to 1.5% by mass of In; and 1 ppm by mass to 50 ppm by mass of Cu, a Ag alloy film excellent in migration resistance and sulfidation resistance can be formed.

In addition, the area of the sputtering surface is set to 0.25 m$^2$ or more and the in-plane Cu concentration distribution $D_{Cu}$ (=$(\sigma_{Cu}/\mu_{Cu}) \times$ 100 [%]) defined by the average value $\mu_{Cu}$ of Cu concentration analysis values on the sputtering surface and the standard deviation $\sigma_{Cu}$ of the Cu concentration analysis values is 40% or less. Thus, even in the case where a Ag alloy film is formed on a substrate having a large area, the Cu concentration of the Ag alloy film is uniform and a Ag alloy film having stable in-plane properties can be formed.

Further, since the oxygen concentration is less than 50 ppm by mass, segregation of Cu due to oxidation can be suppressed, and the above-mentioned in-plane Cu concentration distribution $D_{cu}$ can be set to 40% or less.

Here, it is preferable that the sputtering target for forming a Ag alloy film according to the aspect of the present invention further includes Sb: 0.1% by mass to 3.5% by mass.

According to the sputtering target for forming a Ag alloy film having these features, since the sputtering target includes 0.1% by mass to 3.5% by mass of Sb, the heat resistance of an Ag alloy film to be formed can be improved. The amount of Sb in the Ag alloy film to be formed changes according to sputtering conditions. Therefore, it is preferable that the amount of Sb in the sputtering target for forming a Ag alloy film is adjusted to be within the above-mentioned range according to an objective amount of Sb in the Ag alloy film to be formed and sputtering conditions.

In addition, it is preferable that the sputtering target for forming a Ag alloy film according to the aspect of the present invention further includes Ca: 0.5 ppm by mass to 50 ppm by mass and an in-plane Ca concentration distribution $D_{Ca}$ defined by Expression (2) below is 40% or less:

$$D_{Ca} = (\sigma_{Ca}/\mu_{Ca}) \times 100 \, [\%] \qquad (2).$$

In Expression (2), $\mu_{Ca}$ represents an average value of Ca concentration analysis values obtained by analyzing Ca concentrations at a plurality of points on the sputtering surface, and $\sigma_{Ca}$ represents a standard deviation of the Ca concentration analysis values.

According to the sputtering target for forming a Ag alloy film having these features, even in the case where a Ag alloy film is formed on a substrate having a large area, the Cu concentration and the Ca concentration in the Ag alloy film are uniform and a Ag alloy film having stable in-plane properties can be formed.

Effects of the Invention

As described above, according to the present invention, it is possible to provide a Ag alloy film excellent in migration resistance, heat resistance, and sulfidation resistance, and a sputtering target for forming a Ag alloy film which can form a Ag alloy film exhibiting stable in-plane properties even in the case where the film is formed on a substrate having a large area.

BRIEF DESCRIPTION OF THE DRAWINGS

FIG. 1 is a schematic view showing a sputtering target (planar target) for forming a Ag alloy film according to an embodiment of the present invention, (a) is a plane view and (b) is a side view.

FIG. 2 is a schematic view showing a sputtering target (cylindrical target) for forming a Ag alloy film according to an embodiment of the present invention, (a) is a side view and (b) is a cross-sectional view of (a) taken along line X-X.

FIG. 3 is a view schematically showing a unidirectional solidification apparatus used for producing a Ag alloy ingot which is a material for a sputtering target for forming a Ag alloy film according to an embodiment of the present invention is produced.

FIG. 4 is a view showing sample collecting positions for a migration evaluation test of Examples.

## EMBODIMENTS FOR CARRYING OUT THE INVENTION

Hereinafter, a Ag alloy film and a sputtering target for forming a Ag alloy film according to an embodiment of the present invention will be described.

The Ag alloy film of the embodiment is, for example, a Ag alloy conductive film used as a reflective electrode film for a display, an LED, or the like, as a wiring film for a touch panel or the like, as a transparent conductive film, and the like.

<Ag Alloy Film>

The Ag alloy film of the embodiment has a composition including: 0.1% by mass to 1.5% by mass of In; 1 ppm by mass to 50 ppm by mass of Cu; and 0.5 ppm by mass to 20 ppm by mass of Ca, with the remainder being Ag and inevitable impurities.

In addition, the Ag alloy film of the embodiment may further include 0.01% by mass to 1.0% by mass of Sb.

Hereinafter, the reasons for defining the composition of the Ag alloy film of the embodiment as described above will be described.

(In: 0.1% by mass or more and 1.5% by mass or less)

In is an element having the effect of improving the sulfidation resistance of the Ag alloy film.

Here, in the case where the amount of In is less than 0.1% by mass, there is a concern that the effect of improving sulfidation resistance may not be obtained. On the other hand, in the case where the amount of In is more than 1.5% by mass, the resistivity is increased and there is a concern that properties of a conductive film may not be secured. In addition, the reflectance is decreased and thus there is a concern that properties of a reflective conductive film may not be secured.

Due to the above-described reasons, in the embodiment, the amount of In in the Ag alloy film is set to be in a range of 0.1% by mass to 1.5% by mass. In order to reliably exhibit the above-mentioned effect, the amount of In in the Ag alloy film is preferably set to be in a range of 0.3% by mass to 1.1% by mass.

(Cu: 1 ppm by mass or more and 50 ppm by mass or less)

Cu is an element having the effect of suppressing a Ag ion migration phenomenon.

Here, in the case where the amount of Cu is less than 1 ppm by mass, there is a concern that the Ag ion migration phenomenon may not be sufficiently suppressed. On the other hand, in the case where the amount of Cu is more than 50 ppm by mass, there is a concern that Cu may aggregate on the film surface and fine protrusions (defects) may be formed when the Ag alloy film is subjected to a heat treatment; and thereby, a short circuit of electrodes and wirings may be caused.

Due to the above-described reasons, in the embodiment, the amount of Cu in the Ag alloy film is set to be in a range of 1 ppm by mass to 50 ppm by mass. In order to reliably exhibit the above-mentioned effect, the amount of Cu in the Ag alloy film is preferably set to be in a range of 2 ppm by mass to 20 ppm by mass.

(Sb: 0.01% by mass or more and 1.0 % by mass or less)

Since Sb is an element having the effect of improving the heat resistance of the Ag alloy film, it is preferable to add an appropriate amount of Sb according to properties to be required.

Here, in the case where the amount of Sb in the Ag alloy film is less than 0.01% by mass, there is a concern that the effect of further improving the heat resistance may not be obtained. On the other hand, in the case where the amount of Sb in the Ag alloy film is more than 1.0% by mass, the resistivity is increased and thus there is a concern that properties of a conductive film may not be secured. In addition, the reflectance is decreased and thus there is a concern that properties of a reflective conductive film may not be secured.

Due to the above-described reasons, in the case where the Ag alloy film of the embodiment contains Sb, the amount of Sb in the Ag alloy film is set to be in a range of 0.01% by mass to 1.0% by mass. In order to reliably exhibit the above-mentioned effect, the amount of Sb in the Ag alloy film is preferably set to be in a range of 0.02% by mass to 0.5% by mass.

(Ca: 0.5 ppm by mass or more and 20 ppm or less)

Since Ca is an element having the effect of further improving the migration resistance of the Ag alloy film due to the interaction with Cu, it is preferable to add an appropriate amount of Ca according to properties to be required.

Here, in the case where the amount of Ca is less than 0.5 ppm by mass, there is a concern that the effect of further improving the migration resistance may not be obtained. On the other hand, in the case where the amount of Ca is more than 50 ppm by mass, the Ag alloy film becomes hard and thus there is a concern that the Ag alloy film may be peeled off. Particularly, in a fine wiring pattern or a fine electrode pattern, the film tends to be easily peeled off. Due to the above-described reason, in the case where the Ag alloy film of the embodiment contains Ca, the amount of Ca in the Ag alloy film is set to be in a range of 0.5 ppm by mass to 20 ppm by mass. In order to reliably exhibit the above-mentioned effect, the amount of Ca in the Ag alloy film is preferably set to be in a range of 1 ppm by mass to 20 ppm by mass.

<Sputtering Target for Forming Ag Alloy Film>

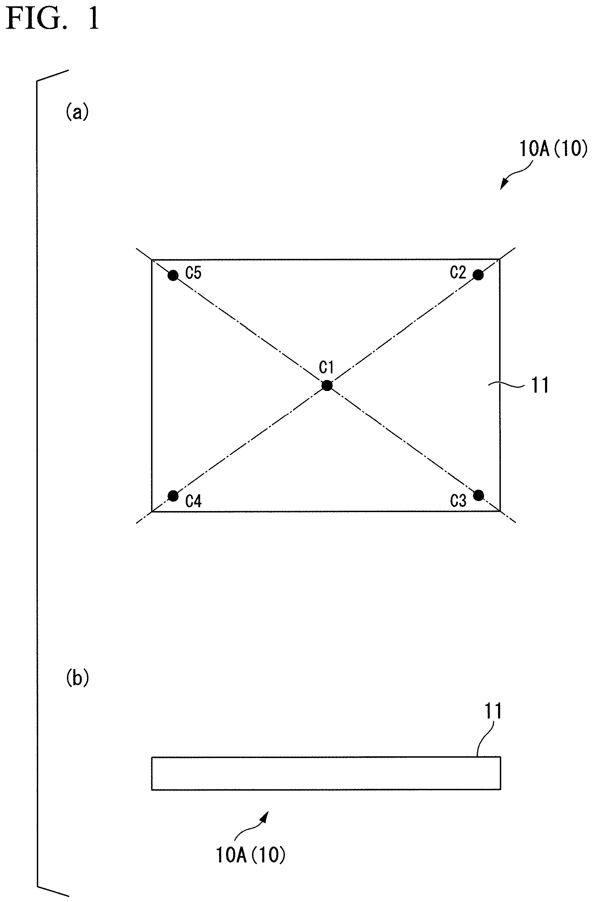

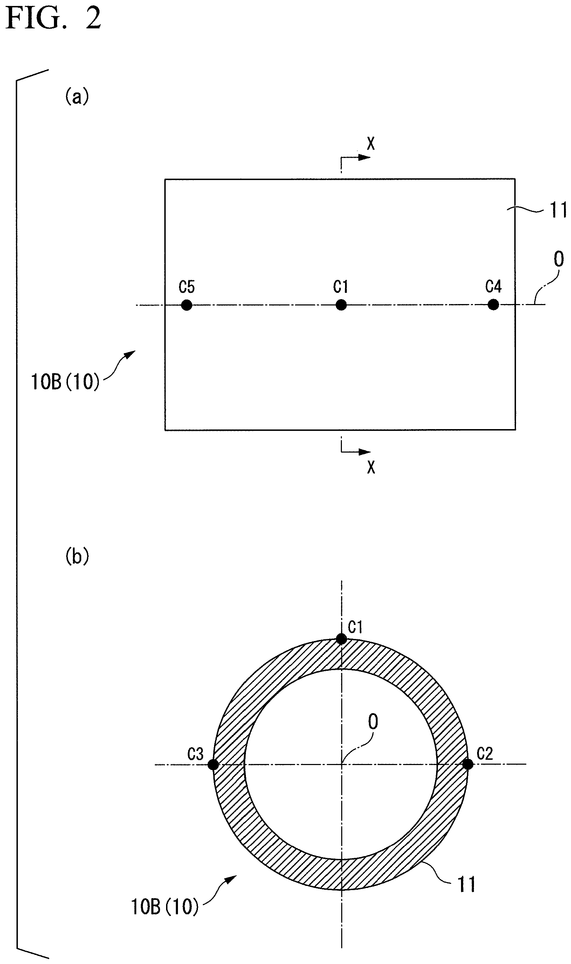

A sputtering target 10 for forming a Ag alloy film of the embodiment is used when the above-mentioned Ag alloy film is formed. In addition, for example, as the sputtering target 10 for forming a Ag alloy film of the embodiment, there are a planar sputtering target 10A which has a planar outer shape as shown in FIG. 1 and a cylindrical sputtering target 10B which has a cylindrical outer shape as shown in FIG. 2.

The sputtering target 10 for forming a Ag alloy film of the embodiment has a composition including: 0.1% by mass to 1.5% by mass of In; 1 ppm by mass to 50 ppm by mass of Cu; 0.5 ppm by mass to 20 ppm by mass Ca, with the remainder being Ag and inevitable impurities. Further, the oxygen concentration is 50 ppm by mass or less.

In addition, the sputtering target 10 for forming a Ag alloy film of the embodiment may further include 0.1% by mass to 3.5% by mass Sb.

Here, the amounts of respective elements of In, Cu, Sb and Ca in the sputtering target 10 for forming a Ag alloy film are defined so that the Ag alloy film having the above-mentioned composition can be formed. Regarding the respective elements of In, Cu and Ca, there is no significant change between the amounts of the elements in the sputtering target 10 for forming a Ag alloy film and the amounts of the elements in the Ag alloy film. Thus, the amounts of the elements are set to be in the above ranges. On the other hand, regarding Sb, there is a concern that there may be a significant change between the amount of Sb in the sputtering target 10 for forming a Ag alloy film and the amount of Sb in the Ag alloy film depending on the sputtering conditions. Thus, the amount of Sb in the sputtering target 10 for forming a Ag alloy film is set to be higher than the amount of Sb in the Ag alloy film.

In the sputtering target 10 for forming a Ag alloy film of the embodiment, the area of the sputtering surface 11 is 0.25 m$^2$ or more and the in-plane Cu concentration distribution $D_{Cu}$ is 40% or less.

Here, the in-plane Cu concentration distribution $D_{Cu}$ is defined by Expression (1) below:

$$D_{Cu}=(\sigma_{Cu}/\mu_{Cu})\times100\ [\%] \qquad (1)$$

wherein, in Expression (1), $\mu_{Cu}$ represents an average value of Cu concentration analysis values obtained by analyzing Cu concentration at a plurality of points on the sputtering surface 11, and $\sigma_{Cu}$ represents a standard deviation of the Cu concentration analysis values.

In addition, in the case where the sputtering target contains Ca, the in-plane Ca concentration distribution $D_{Ca}$ is 40% or less.

Here, the in-plane Ca concentration distribution $D_{Ca}$ is defined by Expression (2) below:

$$D_{Ca}=(\sigma_{Ca}/\mu_{Ca})\times100\ [\%] \qquad (2)$$

wherein, in Expression (2), $\mu_{Ca}$ represents an average value of Ca concentration analysis values obtained by analyzing Ca concentrations at a plurality of points on the sputtering surface 11, and $\sigma_{Ca}$ represents a standard deviation of the Ca concentration analysis values.

Here, in the planar sputtering target 10A shown in FIG. 1, the Cu concentration analysis positions of the sputtering surface 11 are set to five points of a center position C1 of the sputtering surface 11, and positions C2, C3, C4 and C5 at 50 mm away from the corners in the central direction along the diagonal lines. The in-plane Cu concentration distribution $D_{Cu}=(\sigma_{Cu}/\mu_{Cu})\times 100$ [%] is calculated from the average value $\mu_{Cu}$ of Cu concentration analysis values at the five points and the standard deviation $\sigma_{Cu}$ of the Cu concentration analysis values.

In addition, regarding the in-plane Ca concentration distribution $D_{Ca}=(\sigma_{Ca}/\mu_{Ca})\times 100$ [%], the Ca concentrations are measured at the above-mentioned five points. The average value $\mu_{Ca}$ of Ca concentration analysis values at the five points and the standard deviation $\sigma_{Ca}$ of the Ca concentration analysis values are used to calculate the in-plane Ca concentration distribution.

On the other hand, in the cylindrical sputtering target 10B shown in FIG. 2, the Cu concentration analysis positions of the sputtering surface 11 are set to five points of a center position C1 in the direction of an axis line O, a position C2 at 90° in the circumferential direction from the center position C1, a position C3 at 270° in the circumferential direction from the center position C1, and positions C4 and C5 at 50 mm away from the end portions on the extension line of the central position C1 along the axis line O. The in-plane Cu concentration distribution $D_{Cu}=(\sigma_{Cu}/\mu_{Cu})\times100$ [%] is calculated from the average value $\mu_{Cu}$ of Cu concentration analysis values at the five points and the standard deviation $\sigma_{Cu}$ of the Cu concentration analysis values.

In addition, regarding the in-plane Ca concentration distribution $D_{Ca}=(\sigma_{Ca}/\mu_{Ca})\times100$ [%], the Ca concentrations are measured at the above-mentioned five points. The average value $\mu_{Ca}$ of Ca concentration analysis values at the five points and the standard deviation $\sigma_{Ca}$ of the Ca concentration analysis values are used to calculate $D_{Ca}$.

The Cu concentration and the Ca concentration are analyzed by ICP optical emission spectrometry. The analysis is carried out by the following procedure.

A sample is measured and put into a beaker. A dilute nitric acid is added thereto; and thereby, the sample is decomposed. The resultant is gently boiled to remove nitrogen oxide. The resultant is cooled to room temperature and then put into a volumetric flask using pure water. Dilute hydrochloric acid is added little by little while stirring and mixing the solution to precipitate silver chloride. The mixture is further sufficiently stirred and mixed. The resultant is cooled to room temperature and then slightly diluted with pure water. The mixture is stirred and mixed and left to stand still for one night. The mixture is filtered using a filter paper in a dried beaker. The solution is sprayed in an argon plasma, and the emission intensity of each component is measured. The amount of each component is calculated using a calibration curve obtained in advance.

Here, since the oxygen concentration is set to be less than 50 ppm by mass in the sputtering target 10 for forming a Ag alloy film of the embodiment, a variation in the concentrations of Cu and Ca, which are contained in very small amounts, is suppressed. That is, in the case where the oxygen concentration is 50 ppm by mass or more, Cu and Ca, which are contained in very small amounts, are segregated due to oxidation and thus there is a concern that the above-mentioned in-plane Cu concentration distribution $D_{Cu}$ (in-plane Ca concentration distribution $D_{Ca}$) may not be obtained.

In order to reliably suppress segregation of Cu and Ca due to oxidation, it is preferable that the oxygen concentration is set to be less than 30 ppm by mass.

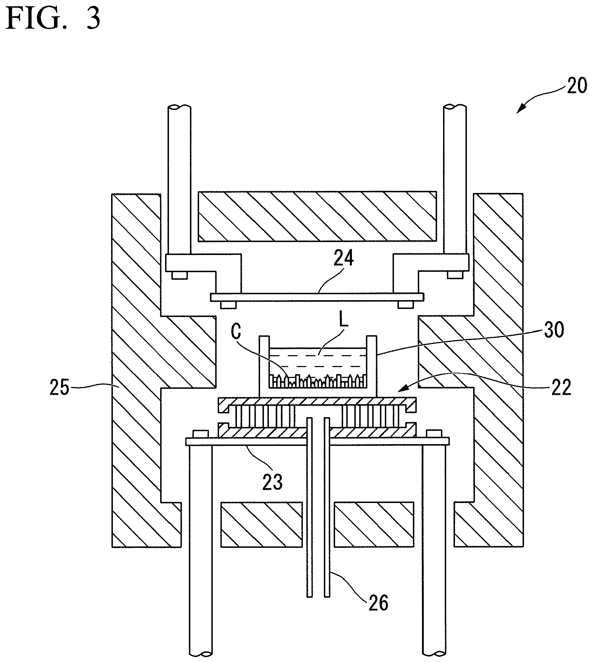

In the embodiment, in order to reduce the oxygen concentration of the sputtering target 10 for forming a Ag alloy film, for example, a unidirectional solidification apparatus 20 shown in FIG. 3 is used to produce a Ag alloy ingot, which is a target material.

The unidirectional solidification apparatus 20 shown in FIG. 3 includes: a crucible 30 in which a molten Ag alloy L is stored; a chilling plate 22 on which the crucible 30 is placed; an underfloor heater 23 which supports the chilling plate 22 from below; and a ceiling heater 24 which is arranged above the crucible 30. In addition, a heat insulating material 25 is provided around the crucible 30.

The chilling plate 22 has a hollow structure and an Ar gas is supplied into the chilling plate through a supply pipe 26.

Next, a method for producing a Ag alloy ingot, which is a target material, using the unidirectional solidification apparatus 20 will be described.

First, melting raw materials are put into the crucible 30, and the ceiling heater 24 and the underfloor heater 23 are energized for heating. Thereby, a molten Ag alloy L is stored in the crucible 30.

Here, as melting raw materials of In, Cu and Sb, single metal raw materials or base alloys containing Ag as a main component are added.

On the other hand, in the case of adding Ca, it is preferable that not a metal Ca but fine particles of a base alloy containing Ag as a main component (for example, Ag-3 % by mass to 10% by mass of Ca) are added after Ag is melted, and the base alloy containing Ag as a main component is prepared and grinded to be fine particles having sizes of 10 mm or less.

Next, the energization to underfloor heater 23 is stopped, and an Ar gas is supplied into the chilling plate 22 through the supply pipe 26. Thereby, the bottom portion of the crucible 30 is cooled. Further, by gradually reducing the amount of current applied to the ceiling heater 24, the molten Ag alloy L in the crucible 30 is cooled from the bottom portion of the crucible 30 and columnar crystals C extending upward from the bottom portion grow and unidirectionally solidify. Thus, a Ag alloy ingot can be obtained.

At this time, the oxygen in the molten Ag alloy L moves upward and is emitted from the surface of the molten alloy so that the oxygen concentration in the Ag alloy ingot is greatly decreased. Thus, oxidation of Cu and Ca in the Ag alloy ingot is suppressed, and segregation of Cu and Ca due to oxidation can be suppressed.

The Ag alloy ingot obtained in the above-mentioned manner is subjected to plastic working such as rolling, extrusion, and the like, a heat treatment, machining, and the like to produce a planar sputtering target 10A shown in FIG. 1 or a cylindrical sputtering target 10B shown in FIG. 2.

Since the Ag alloy film of the embodiment having the above-mentioned features contains 1 ppm by mass to 50 ppm by mass of Cu, the migration resistance of the Ag alloy film can be improved. Thus, even in the case where a fine electrode pattern and a fine wiring pattern are formed by using the Ag alloy film of the embodiment, the occurrence of a short circuit caused by Ag ion migration can be suppressed.

In addition, since the Ag alloy film contains 0.1% by mass to 1.5% by mass of In, the sulfidation resistance of the Ag alloy film can be improved. Accordingly, even in the case where the film is exposed to a sulfur component included in the production process and in the atmosphere of the environment, the resistivity and the reflectance are rarely deteriorated, and stable properties of an electrode film or a wiring film can be maintained.

In addition, in the case where the Ag alloy film of the embodiment further contains 0.01% by mass to 1.0% by mass of Sb, the heat resistance of the Ag alloy film can be improved. Accordingly, it is possible to suppress the deterioration of the properties after the heat treatment. since the Ag alloy film of the embodiment further contains 0.5 ppm by mass to 20 ppm by mass of Ca, the migration resistance of the Ag alloy film is further improved by the interaction with Cu.

Since the sputtering target 10 for forming a Ag alloy film of the embodiment contains: 0.1% by mass to 1.5% by mass of In; and 1 ppm by mass to 50 ppm by mass of Cu, as described above, a Ag alloy film excellent in migration resistance and sulfidation resistance can be formed.

In addition, in the case where the sputtering target 10 for forming a Ag alloy film contains 0.1 % by mass to 3.5% by mass of Sb, a Ag alloy film further having excellent heat resistance can be formed.

Further, since the sputtering target 10 for forming a Ag alloy film contains 0.5 ppm by mass to 20 ppm by mass of Ca, a Ag alloy film further having excellent migration resistance is formed.

Further, since the oxygen concentration in the sputtering target 10 for forming a Ag alloy film of the embodiment is less than 50 ppm by mass, segregation of Cu and Ca due to oxidation can be suppressed.

Further, in the sputtering target 10 for forming a Ag alloy film of the embodiment, the area of the sputtering surface 11 is 0.25 $m^2$ or more, and the in-plane Cu concentration distribution $D_{Cu}$ ($=(\sigma_{Cu}/\mu_{Cu})\times100$ [%]) defined by the average value $\mu_{Cu}$ of the Cu concentration analysis values on the sputtering surface 11 and the standard deviation $\sigma_{Cu}$ of the Cu concentration analysis values is 40% or less. Therefore, even in the case where the Ag alloy film is formed on a substrate having a large area, the Cu concentration in the Ag alloy film is uniform and thus a Ag alloy film having stable properties without a local variation in the properties can be formed.

As described above, in the case where the sputtering target contains Ca, the in-plane Ca concentration distribution $D_{Ca}$ ($=(\sigma_{Ca}/\mu_{Ca})\times100$ [%]) defined by the average value $\mu_{Ca}$ of the Ca concentration analysis values on the sputtering surface 11 and the standard deviation $\sigma_{Ca}$ of the Ca concentration analysis values is 40% or less. Therefore, even in the case where the Ag alloy film is formed on a substrate having a large area, the Ca concentration of the Ag alloy film is uniform and thus a Ag alloy film having stable properties without a local variation in the properties can be formed.

In addition, since the Ag alloy ingot, which is a target material, is produced using the unidirectional solidification apparatus 20 shown in FIG. 3 in the embodiment, the oxygen concentration in the sputtering target 10 for forming a Ag alloy film can be decreased and segregation of Cu and Ca due to oxidation can be suppressed.

Further, in the embodiment, in the case of adding Ca, a base alloy consisting of Ag and 3% by mass to 10% by mass of Ca is prepared and grinded to be fine particles having sizes of 10 mm or less. The fine particles are added into the molten Ag alloy L. Thus, Ca can be uniformly melted.

The embodiment of the present invention has been described above. However, the present invention is not limited thereto and modifications can be made appropriately within a range not departing from the features of the invention.

For example, in the embodiment, the Ag alloy film which is used as a Ag alloy conductive film for a reflective conductive film of a display, an LED, or the like, for a wiring film of a touch panel or the like, for a transparent conductive film, and the like has been described. However, the embodiment is not limited thereto and may be applied to other purposes.

In addition, in the embodiment, the method for producing a Ag alloy ingot, which is a target material, using the unidirectional solidification apparatus, has been described. However, the embodiment is not limited thereto and a Ag alloy ingot may be produced using a semi-continuous casting apparatus and a continuous casting apparatus. Any Ag alloy ingot may be used as long as the oxygen concentration of the sputtering target for forming a Ag alloy film prepared from the obtained Ag alloy ingot is less than 50 ppm by mass.

The sputtering target for forming a Ag alloy film of the embodiment has an average crystal grain diameter of 600 $\mu$m or less, which is measured by an intercept method shown in ASTM E-112, and the sputtering target includes, as impurities, less than 50 ppm by mass of Fe, less than 50 ppm by mass of Bi, and less than 50 ppm by mass of Pb. In addition, the sputtering target has an arithmetical mean roughness (Ra) of 5 $\mu$m or less as the surface roughness of the sputtering surface of the target material.

EXAMPLES

Hereinafter, the results of the evaluation tests for evaluating the effects of the Ag alloy film and the sputtering target for forming a Ag alloy film according to the present invention will be described.

<Sputtering Target for Forming Ag Alloy Film>

As melting raw materials, Ag having a purity of 99.9% by mass or higher, Cu and Sb having purities of 99.9% by mass or higher, and a base alloy consisting of Ag and 7% by mass of Ca (having grain diameters of 10 mm or less) were prepared and weighed so as to have a predetermined composition shown in Table 1.

Next, Ag was melted using the unidirectional solidification apparatus shown in FIG. 3 in an inert gas atmosphere. Sb and the base alloy consisting of Ag and 7% by mass of Ca were added into the obtained molten Ag alloy, and the mixture was melted in the inert gas atmosphere to obtain a molten Ag alloy. Then, the molten Ag alloy was unidirectionally solidified to produce a Ag alloy ingot.

Next, the Ag alloy ingot produced by the unidirectional solidification method was subjected to cold rolling at a reduction rate of 70% to obtain a sheet material. Next, the sheet material was subjected to a heat treatment of holding the sheet material at 600°C for 2 hours in the atmosphere. Then, machining was performed to produce sputtering targets (planar sputtering targets) having compositions of Invention Example 7, Reference Examples 1 to 6 and 8, and Comparative Examples 1 to 6 with a size of 570 mm×690 mm×thickness 8 mm.

In addition, the Ag alloy ingot produced by the unidirectional solidification method was subjected to hot extrusion under the conditions where the extrusion ratio was 7 and the temperature of the material immediately after extrusion was 650°C. Thus, a cylindrical body was obtained. After the extrusion, the cylindrical body was cooled to a temperature of 200°C or lower within 10 minutes. Further, the cylindrical body, which had been subjected to the hot extrusion process, was subjected to cold drawing at a working ratio of 30%. A heat treatment was performed to hold the cylindrical body, which had been subjected to the cold drawing process, at a temperature of 550°C. By subjecting the cylindrical body to machining, sputtering targets (cylindrical sputtering targets) having compositions of Invention Example 17, Reference Examples 11 to 16 and 18, and Comparative Examples 11 to 16 with a size of: an outer diameter of 155 mm; an inner diameter of 135 mm; and an axial direction length of 650 mm were prepared.

Further, for Comparative Examples 7 and 17, instead of using the unidirectional solidification apparatus, the molten Ag alloy was poured into a casting mold having a predetermined shape of cavity to prepare a Ag alloy ingot. Then, the Ag alloy ingot was subjected to the above-mentioned production process to prepare a planar sputtering target (Comparative Example 7) having a size of 570 mm×690 mm×thickness 8 mm and a cylindrical sputtering target (Comparative Example 17) having a size of: an outer diameter of 155 mm; an inner diameter of 135 mm; and an axial direction length of 650 mm.

<Oxygen Concentration>

The oxygen concentrations of the sputtering targets obtained in the above-mentioned manner were analyzed. The oxygen concentration was analyzed by using an oxygen and nitrogen analyzer EMGA-550, manufactured by HORIBA, Ltd., according to an inert gas impulse heat melting method (non-dispersive infrared absorption method). The measurement results are shown in Tables 1 and 2.

<In-plane Concentration Distribution>

Next, the in-plane Cu concentration distributions $D_{Cu}$ of the sputtering targets obtained in the above-mentioned manner were calculated by the method described in the above-mentioned embodiment section. In addition, in the case where the sputtering targets contained Ca, the in-plane Ca concentration distributions $D_{Ca}$ were calculated. The calculation results are shown in Tables 1 and 2.

<Ag Alloy Film>

The above-mentioned sputtering targets (planar sputtering targets) of Invention Example 7, Reference Examples 1 to 6 and 8, and Comparative Examples 1 to 6 were used to form Ag alloy films of Invention Example 57, Reference Examples 51 to 56 and 58, and Comparative Examples 51 to 56 under the following conditions.

Each of the sputtering targets of Invention Example 7, Reference Examples 1 to 6 and 8, and Comparative Examples 1 to 6 was soldered to a backing plate made of oxygen-free copper using indium solder to prepare a target composite. The target composite was mounted in a sputtering apparatus and sputtering was carried out under the conditions of: a distance from a glass substrate: 70 mm; an electric powder: direct current of 5.5 kW; a reached vacuum level: $5×10^{-5}$ Pa; and an Ar gas pressure: 0.5 Pa. Thus, a Ag alloy film having a thickness of 100 nm was formed on the surface of the glass substrate. As the glass substrate, a large substrate having a size of 370 mm×470 mm was used. In addition, the film formation by the sputtering was carried out in a state where the substrate was fixed above the target and the substrate and the target faced each other.

In addition, the above-mentioned sputtering targets (cylindrical sputtering targets) of Invention Example 17, Reference Examples 11 to 16 and 18, and Comparative Examples 11 to 16 were used to form Ag alloy films of Invention Example 67, Reference Examples 61 to 66 and 68, and Comparative Examples 61 to 66 under the following conditions.

Each of the sputtering targets of Invention Example 17, Reference Examples 11 to 16 and 18, and Comparative Examples 11 to 16 was soldered to a backing tube made of stainless steel using indium solder to prepare a target composite. The target composite was mounted in a sputtering apparatus and sputtering was carried out under the conditions of: a distance from a glass substrate: 60 mm; powder: direct current of 1.0 kW; a reached vacuum level: $5 \times 10^{-5}$ Pa; and an Ar gas pressure: 0.5 Pa. Thus, a Ag alloy film having a thickness of 100 nm was formed on the surface of the glass substrate. In addition, a magnet in the cathode was fixed during sputtering discharge, and sputtering was carried out while rotating the cylindrical target around the magnet at a rotation number of 10 rpm. As the glass substrate, a large substrate having a size of 370 mm×470 mm was used. In the film formation by the sputtering, an inline method was adopted in which the film formation was carried out while the substrate was conveyed and moved above the target. The conveying rate was set to 10 mm/sec, and a Ag alloy film of 100 nm was formed by one pass conveying.

<Ag Alloy Film Composition Analysis>

The compositions of the Ag alloy films obtained in the above-mentioned manner were measured by the following method.

Using the same sputtering target, a thick film having a thickness of 0.5 μm was formed on the glass substrate under the same conditions as described above. A plurality of substrates with the thick films were prepared and the whole amount of the thick films of these substrates was dissolved, and the composition of the film was analyzed by ICP optical emission spectrometry. Thus, the composition of the film was obtained. The analysis results of the compositions of the Ag alloy films are shown in Tables 3 and 4.

<Measurement of Resistivity >

The sheet resistance values of the thus-obtained Ag alloy films after the film formation were measured by a four-point probe method and the resistivities were calculated. The obtained resistivities after the film formation are shown in Tables 5 and 6.

<Measurement of Reflectance>

The reflectances of the thus-obtained Ag alloy films after the film formation at a wavelength of 550 nm were measured by a spectrophotometer (U-4100, manufactured by manufactured by Hitachi High-Technologies Corporation). The obtained reflectances after the film formation are shown in Tables 5 and 6.

<Heat Treatment>

A square-shaped sample having each side length of 100 mm was cut out from the glass substrate on which the Ag alloy film was formed, and the sample was subjected to a heat treatment at a temperature of 250°C for a holding time of 1 hour in the atmosphere.

The film surface after the heat treatment was observed by Auger electron spectroscopy and whether or not protrusions were present on the film surface was confirmed. The observation results are shown in Tables 5 and 6.

In addition, the resistivity and the reflectance at a wavelength of 550 nm of the Ag alloy film after the heat treatment were measured in the above-mentioned manner. The evaluation results are shown in Tables 5 and 6.

<Sulfidation Test>

A square-shaped sample having each side length of 50 mm was cut out from the glass substrate on which the Ag alloy film was formed, and the sample was immersed in an aqueous $Na_2S$ solution having a concentration of 0.01% by mass for 1 hour at room temperature.

The reflectance of the Ag alloy film at a wavelength of 550 nm after the immersion was measured by the above-mentioned manner and the obtained value was used as an index for sulfidation resistance. The measurement results are shown in Tables 5 and 6.

<Evaluation of Migration Resistance>

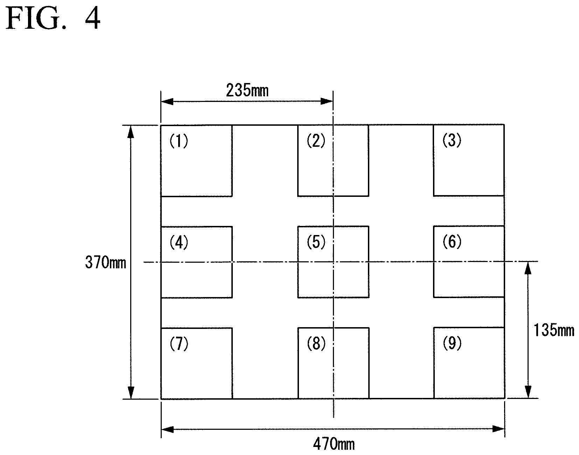

Square-shaped samples having a side of 100 mm were cut out from nine positions shown in FIG. 4 on the glass substrate on which the Ag alloy film was formed. A positive photoresist was coated on these samples, and the samples were subjected to an exposure treatment and a developing treatment. Next, the resist film was stripped, and a comb-shaped electrode pattern with an interval of 100 μm was prepared.

A Cu tape was attached to the pad portion of the comb-shaped electrode pattern and a conductive wire was soldered onto the Cu tape so that the sample was connected to an ion migration measurement system (AMI-50-U, manufactured by ESPEC Corp.).

The current value of the sample was measured and recorded while applying a voltage of 10 V between electrodes under a constant temperature and humidity condition where the temperature was 85°C and the humidity was 85%. In this state, the sample was held for 100 hours, and then whether or not a short circuit occurred between the electrodes at each measurement position was confirmed. The number of points where a short circuit occurred among the nine measurement positions, is shown in Table 5 and 6.

<Adhesion Test>

Similar to the sample used for the migration test, the Ag alloy film which was formed on the glass substrate was subjected to patterning to prepare a comb-shaped electrode pattern with an interval of 100 μm. A commercially available cellophane tape (Scotch tape 375, manufactured by 3M) was attached to the electrode for adhesion. The tape was slowly peeled off. Next, the comb-shaped electrode was observed by an optical microscope and whether or not the comb-shaped electrode portion was peeled off was confirmed. The results are shown in Tables 5 and 6.

Table 1

| | | Component composition of target | | | | | | In-plane concentration distribution | |
|---|---|---|---|---|---|---|---|---|---|
| | | In % by mass | Cu ppm by mass | Sb % by mass | Ca ppm by mass | Oxygen ppm by mass | Ag | $D_{Cu}$ % | $D_{ca}$ % |
| Reference and Invention Examples | 1 | 0.10 | 5.0 | - | - | 20 | Remainder | 28 | - |
| | 2 | 1.50 | 4.0 | - | - | 18 | Remainder | 31 | - |
| | 3 | 0.60 | 1.0 | - | - | 21 | Remainder | 25 | - |
| | 4 | 0.40 | 50.0 | - | - | 15 | Remainder | 22 | - |
| | 5 | 0.70 | 15.0 | 0.10 | - | 20 | Remainder | 32 | - |
| | 6 | 0.50 | 12.0 | 3.50 | - | 25 | Remainder | 36 | - |
| | 7* | 0.80 | 10.0 | - | 0.5 | 15 | Remainder | 24 | 32 |
| | 8 | 1.10 | 7.0 | - | 50.0 | 22 | Remainder | 30 | 36 |
| Comparative Examples | 1 | 0.030 | 8.0 | - | - | 30 | Remainder | 34 | - |
| | 2 | 2.00 | 6.0 | - | - | 18 | Remainder | 24 | - |
| | 3 | 0.50 | 0.1 | - | - | 33 | Remainder | 31 | - |
| | 4 | 1.20 | 55.0 | - | - | 20 | Remainder | 23 | - |
| | 5 | 0.30 | 16.0 | 4.00 | - | 25 | Remainder | 27 | - |
| | 6 | 0.50 | 2.0 | - | 60.0 | 23 | Remainder | 32 | 38 |
| | 7 | 0.70 | 3.0 | - | - | 65 | Remainder | 53 | - |
| * Invention Example | | | | | | | | | |

Table 2

| | | Component composition of target | | | | | | In-plane concentration distribution | |
|---|---|---|---|---|---|---|---|---|---|
| | | In % by mass | Cu ppm by mass | Sb % by mass | Ca ppm by mass | Oxygen ppm by mass | Ag | $D_{Cu}$ % | $D_{Ca}$ % |
| Reference and Invention Examples | 11 | 0.10 | 3.0 | - | - | 25 | Remainder | 24 | - |
| | 12 | 1.50 | 5.0 | - | - | 21 | Remainder | 25 | - |
| | 13 | 0.50 | 1.0 | - | - | 30 | Remainder | 35 | - |
| | 14 | 0.60 | 50.0 | - | - | 24 | Remainder | 22 | - |
| | 15 | 0.80 | 7.0 | 0.10 | - | 18 | Remainder | 25 | - |
| | 16 | 1.00 | 20.0 | 3.50 | - | 22 | Remainder | 28 | - |
| | 17* | 0.40 | 11.0 | - | 0.5 | 22 | Remainder | 24 | 27 |
| | 18 | 0.50 | 6.0 | - | 50.0 | 28 | Remainder | 34 | 33 |
| Comparative Examples | 11 | 0.05 | 10.0 | - | - | 30 | Remainder | 38 | - |
| | 12 | 1.90 | 20.0 | - | - | 19 | Remainder | 28 | - |
| | 13 | 0.60 | 70.0 | - | - | 25 | Remainder | 32 | - |
| | 14 | 0.50 | 0.3 | - | - | 17 | Remainder | 25 | - |
| | 15 | 0.40 | 5.0 | 4.50 | - | 28 | Remainder | 35 | - |
| | 16 | 0.90 | 8.0 | - | 70.0 | 32 | Remainder | 33 | 30 |
| | 17 | 1.10 | 10.0 | - | - | 60 | Remainder | 55 | - |
| * Invention Example | | | | | | | | | |

Table 3

| | | Target | Component composition of film | | | | |
|---|---|---|---|---|---|---|---|
| | | | In % by mass | Cu ppm by mass | Sb % by mass | Ca ppm by mass | Ag |
| Reference and Invention Examples | 51 | Reference Example 1 | 0.11 | 5.0 | - | - | Remainder |
| | 52 | Reference Example 2 | 1.40 | 4.0 | - | - | Remainder |
| | 53 | Reference Example 3 | 0.65 | 1.0 | - | - | Remainder |
| | 54 | Reference Example 4 | 0.38 | 49.0 | - | - | Remainder |
| | 55 | Reference Example 5 | 0.61 | 13.0 | 0.01 | - | Remainder |
| | 56 | Reference Example 6 | 0.44 | 12.0 | 0.94 | - | Remainder |
| | 57* | Invention Example 7 | 0.84 | 9.0 | - | 0.5 | Remainder |
| | 58 | Reference Example 8 | 1.00 | 7.0 | - | 49.0 | Remainder |
| Comparative Examples | 51 | Comparative Example 1 | 0.03 | 7.0 | - | - | Remainder |
| | 52 | Comparative Example 2 | 1.88 | 6.0 | - | - | Remainder |
| | 53 | Comparative Example 3 | 0.45 | 0.1 | - | - | Remainder |
| | 54 | Comparative Example 4 | 1.22 | 54.0 | - | - | Remainder |
| | 55 | Comparative Example 5 | 0.31 | 15.0 | 1.40 | - | Remainder |
| | 56 | Comparative Example 6 | 0.53 | 2.0 | - | 57.0 | Remainder |
| * Invention Example | | | | | | | |

Table 4

| | | Target | Component composition of film | | | | |
|---|---|---|---|---|---|---|---|
| | | | In % by mass | Cu ppm by mass | Sb % by mass | Ca ppm by mass | Ag |
| Reference and Invention Examples | 61 | Reference Example 11 | 0.10 | 3.0 | - | - | Remainder |
| | 62 | Reference Example 12 | 1.40 | 4.0 | - | - | Remainder |
| | 63 | Reference Example 13 | 0.45 | 1.0 | - | - | Remainder |
| | 64 | Reference Example 14 | 0.56 | 49.0 | - | - | Remainder |
| | 65 | Reference Example 15 | 0.81 | 6.0 | 0.015 | - | Remainder |
| | 66 | Reference Example 16 | 0.92 | 20.0 | 0.920 | - | Remainder |
| | 67* | Invention Example 17 | 0.36 | 11.0 | - | 0.51 | Remainder |
| | 68 | Reference Example 18 | 0.47 | 5.0 | - | 48.00 | Remainder |
| Comparative Examples | 61 | Comparative Example 11 | 0.052 | 7.7 | - | - | Remainder |
| | 62 | Comparative Example 12 | 1.88 | 19.0 | - | - | Remainder |
| | 63 | Comparative Example 13 | 0.63 | 0.2 | - | - | Remainder |
| | 64 | Comparative Example 14 | 0.48 | 70.0 | - | - | Remainder |
| | 65 | Comparative Example 15 | 0.37 | 4.8 | 2.000 | - | Remainder |
| | 66 | Comparative Example 16 | 0.91 | 7.2 | - | 63.00 | Remainder |
| * Invention Example | | | | | | | |

Table 5

| | | Resistivity ($\mu\Omega\cdot$cm) | | Reflectance at wavelength of 550 nm (%) | | | Film observation after heat treatment (presence or absence of protrusions) | Adhesion test (presence or absence of peeling-off) | Migration resistance evaluation (number of short circuit points) |
|---|---|---|---|---|---|---|---|---|---|
| | | After film formation | After heat treatment | After film formation | After heat treatment | Sulfidation test | | | |
| Reference and Invention Examples | 51 | 3.2 | 4.6 | 97.0 | 82.3 | 57.6 | Absence | Absence | 2 |
| | 52 | 5.3 | 7.7 | 95.1 | 85.0 | 69.2 | Absence | Absence | 3 |
| | 53 | 4.2 | 6.1 | 96.3 | 84.7 | 64.5 | Absence | Absence | 3 |
| | 54 | 3.9 | 5.7 | 96.8 | 83.4 | 62.2 | Absence | Absence | 2 |
| | 55 | 4.3 | 4.1 | 96.1 | 95.5 | 63.8 | Absence | Absence | 3 |
| | 56 | 7.2 | 4.3 | 95.3 | 95.0 | 63.4 | Absence | Absence | 2 |
| | 57* | 4.8 | 7.0 | 95.7 | 84.6 | 63.5 | Absence | Absence | 0 |
| | 58 | 4.9 | 7.1 | 95.5 | 85.2 | 64.1 | Absence | Absence | 0 |
| Comparative Examples | 51 | 3.1 | 4.5 | 96.9 | 77.4 | 47.9 | Absence | Absence | 2 |
| | 52 | 6.1 | 8.8 | 94.4 | 84.9 | 70.3 | Absence | Absence | 1 |
| | 53 | 3.9 | 5.7 | 96.4 | 85.0 | 62.8 | Absence | Absence | 9 |
| | 54 | 5.0 | 7.3 | 95.3 | 85.3 | 68.6 | Presence | Absence | 1 |
| | 55 | 8.1 | 4.4 | 94.1 | 94.0 | 63.0 | Absence | Absence | 2 |
| | 56 | 4.0 | 5.8 | 96.0 | 85.1 | 63.7 | Absence | Presence | 0 |
| * Invention Example | | | | | | | | | |

Table 6

| | | Resistivity (μΩ·cm) | | Reflectance at wavelength of 550 nm (%) | | | Film observation after heat treatment (presence or absence of protrusions) | Adhesion test (presence or absence of peeling-off) | Migration resistance evaluation (number of short circuit points) |
|---|---|---|---|---|---|---|---|---|---|
| | | After film formation | After heat treatment | After film formation | After heat treatment | Sulfidation test | | | |
| Reference and Invention Examples | 61 | 3.3 | 4.8 | 97.1 | 81.2 | 58.3 | Absence | Absence | 1 |
| | 62 | 5.3 | 7.7 | 95.2 | 84.8 | 69.5 | Absence | Absence | 1 |
| | 63 | 3.9 | 5.7 | 96.8 | 85.5 | 63.4 | Absence | Absence | 4 |
| | 64 | 4.1 | 5.9 | 96.5 | 85.2 | 63.8 | Absence | Absence | 1 |
| | 65 | 4.7 | 3.9 | 96.4 | 96.6 | 63.2 | Absence | Absence | 3 |
| | 66 | 7.9 | 4.0 | 95.6 | 95.3 | 63.5 | Absence | Absence | 2 |
| | 67* | 3.7 | 5.4 | 96.9 | 85.5 | 62.6 | Absence | Absence | 0 |
| | 68 | 4.0 | 5.8 | 96.9 | 85.2 | 63.9 | Absence | Absence | 0 |
| Comparative Examples | 61 | 3.1 | 4.5 | 97.2 | 78.5 | 47.6 | Absence | Absence | 1 |
| | 62 | 6.2 | 9.0 | 94.3 | 84.2 | 71.8 | Absence | Absence | 2 |
| | 63 | 4.4 | 6.4 | 96.3 | 84.9 | 64.5 | Absence | Absence | 9 |
| | 64 | 4.1 | 5.9 | 96.9 | 85.5 | 64.0 | Presence | Absence | 2 |
| | 65 | 9.1 | 3.8 | 94.1 | 92.5 | 63.2 | Absence | Absence | 3 |
| | 66 | 4.8 | 7.0 | 95.5 | 83.7 | 64.2 | Absence | Presence | 0 |
| * Invention Example | | | | | | | | | |

In the Ag alloy films of Comparative Examples 51 and 61 formed by using the sputtering targets of Comparative Examples 1 and 11 in which the amounts of In were smaller than the range of the embodiment, the reflectances after the sulfidation test were greatly decreased.

In the Ag alloy films of Comparative Examples 52 and 62 formed by using the sputtering targets of Comparative Examples 2 and 12 in which the amounts of In were larger than the range of the embodiment, the resistivities after the film formation were high and the conductivities were not sufficient.

In the Ag alloy films of Comparative Examples 53 and 63 formed by using the sputtering targets of Comparative Examples 3 and 13 in which the amounts of Cu were smaller than the range of the embodiment, the migration resistances were deteriorated.

In the Ag alloy films of Comparative Examples 54 and 64 formed by using the sputtering targets of Comparative Examples 4 and 14 in which the amounts of Cu were larger than the range of the embodiment, protrusions after the heat treatment were observed.

In the Ag alloy films of Comparative Examples 55 and 65 formed by using the sputtering targets of Comparative Examples 5 and 15 in which the amounts of Sb were larger than the range of the embodiment, the resistivities after the film formation were high and the conductivities were not sufficient.

In the Ag alloy films of Comparative Examples 56 and 66 formed by using the sputtering targets of Comparative Examples 6 and 16 in which the amounts of Ca were larger than the range of the embodiment, a peeled-off portion was confirmed in the adhesion test.

In addition, in the sputtering targets of Comparative Examples 7 and 17 in which the amounts of oxygen exceeded the range of the embodiment, it was confirmed that the in-plane Cu concentration distributions $D_{Cu}$ were more than 40% as shown in Tables 1 and 2, and the Cu concentrations of the sputtering surface were not uniform.

In contrast, in the Ag alloy films of Invention Examples 57 and 67 and Reference Examples 51 to 56, 58, 61 to 66 and 68 formed by using the sputtering targets of Invention Examples 7 and 17 and Reference Examples 1 to 6, 8, 11 to 16 and 18 in which the amounts of In, Cu, Sb and Ca were within the ranges of the embodiment, the resistivities after the film formation were low and the conductivities were excellent. In addition, the resistivities and the reflectances were not greatly deteriorated even after the heat treatment, and the films exhibited heat resistance. Further, the reflectances were not greatly deteriorated even after the sulfidation test and the films exhibited sulfidation resistance. The migration resistance evaluations were also satisfactory.

In addition, in the sputtering targets of Invention Examples 7 and 17 and Reference Examples 1 to 6, 8, 11 to 16 and 18 in which the amounts of oxygen were less than 50 ppm by mass, it was confirmed that the in-plane Cu concentration distributions $D_{Cu}$ and the in-plane Ca concentration distributions $D_{Ca}$ were low and the Cu concentrations and the Ca concentrations of the sputtering surface were uniform.

Industrial Applicability

The Ag alloy film of the present invention is excellent in migration resistance, heat resistance, and sulfidation resistance. By using the sputtering target of the present invention, a Ag alloy film having stable in-plane properties can be formed even in the case where the film is formed on a substrate having a large area. Therefore, the Ag alloy film and the sputtering target of the present invention can be suitably applied to a Ag alloy film used as a reflective electrode film for a display, an LED or the like, as a wiring film for a touch panel or the like, as a transparent conductive film, and the like, and a production process thereof.

Description of Reference Signs

    10 Sputtering target for forming Ag alloy film
    11 Sputtering surface

**Claims**

1. An Ag alloy film having a composition comprising:

        In: 0.1% by mass to 1.5% by mass;
        Cu: 1 ppm by mass to 50 ppm by mass;
        Ca: 0.5 ppm by mass to 20 ppm by mass; and
        optionally Sb: 0.01% by mass to 1.0% by mass,

with the remainder being Ag and inevitable impurities.

2. A planar and rectangular or a cylindrical sputtering target for forming the Ag alloy film according to claim 1, the sputtering target having a composition comprising:

In: 0.1% by mass to 1.5% by mass;
Cu: 1 ppm by mass to 50 ppm by mass;
Ca: 0.5 ppm by mass to 20 ppm by mass; and
optionally Sb: 0.1% by mass to 3.5% by mass,
with the remainder being Ag and inevitable impurities,
wherein an oxygen concentration in the sputtering target is less than 50 ppm by mass,
an area of a sputtering surface is 0.25 m$^2$ or more, and
an in-plane Cu concentration distribution $D_{Cu}=(\sigma_{Cu}/\mu_{Cu})\times 100$ [%] is 40% or less, and the in-plane Cu concentration distribution $D_{Cu}$ is defined by an average value, $\mu_{Cu}$ of Cu concentration analysis values obtained by analyzing Cu concentrations at five points on the sputtering surface (11), and by a standard deviation, $\sigma_{Cu}$ of the Cu concentration analysis values, wherein in the planar and rectangular sputtering target the five points are a center position C1 of the sputtering surface (11) and positions C2, C3, C4 and C5 at 50 mm away from the corners in the central direction along the diagonal lines, and in the cylindrical sputtering target the five points are a center position C1 in the direction of an axis line O, a position C2 at 90° in the circumferential direction from the center position C1, a position C3 at 270° in the circumerential direction from the center position C1, and positions C4 and C5 at 50 mm away from the end portions on the extension line of the central position C1 along the axis line O.

3. The sputtering target according to claim 2,

wherein an in-plane Ca concentration distribution $D_{Ca}=(\sigma_{Ca}/\mu_{Ca})\times 100$ [%] is 40% or less, and the in-plane Ca concentration distribution $D_{Ca}$ is defined by an average value, $\mu_{Ca}$ of Ca concentration analysis values obtained by analyzing Ca concentrations at five points on the sputtering surface as defined in claim 2, and by a standard deviation, $\sigma_{Ca}$ of the Ca concentration analysis values.

**Patentansprüche**

1. Ag-Legierungsfilm mit einer Zusammensetzung, umfassend:

In: 0,1 Masse-% bis 1,5 Masse-%,
Cu: 1 Masse-ppm bis 50 Masse-ppm,
Ca: 0,5 Masse-ppm bis 20 Masse-ppm und
gegebenenfalls Sb: 0,01 Masse-% bis 1,0 Masse-%,

wobei der Rest Ag und unvermeidliche Verunreinigungen ist.

2. Planares und rechteckiges oder zylindrisches Sputtertarget zur Bildung des Ag-Legierungsfilms gemäß Anspruch 1, wobei das Sputtertarget eine Zusammensetzung aufweist, umfassend:

In: 0,1 Masse-% bis 1,5 Masse-%,
Cu: 1 Masse-ppm bis 50 Masse-ppm,
Ca: 0,5 Masse-ppm bis 20 Masse-ppm und
gegebenenfalls Sb: 0,01 Masse-% bis 3,5 Masse-%,

wobei der Rest Ag und unvermeidliche Verunreinigungen ist,
wobei eine Sauerstoffkonzentration in dem Sputtertarget weniger als 50 Masse-ppm beträgt,
eine Fläche einer Sputteroberfläche 0,25 m$^2$ oder mehr beträgt und
eine Cu-Konzentrationsverteilung in der Ebene $D_{Cu}=(\sigma_{Cu}/\mu_{Cu})\times 100$ [%] 40 % oder weniger beträgt und die Cu-Konzentrationsverteilung in der Ebene $D_{Cu}$ durch einen Durchschnittswert $\mu_{Cu}$ von Cu-Konzentrationsanalysewerten, die durch Analyse von Cu-Konzentrationen an fünf Stellen auf der Sputteroberfläche (11) erhalten werden, und durch eine Standardabweichung $\sigma_{Cu}$ der Cu-Konzentrationsanalysewerte definiert ist, wobei in dem planaren und rechteckigen Sputtertarget die fünf Stellen eine Mittenposition C1 der Sputteroberfläche (11) und die Positionen C2, C3, C4 und C5 50 mm entfernt von den Ecken in zentraler Richtung entlang der Diagonalen sind und in dem zylindrischen Sputtertarget die fünf Positionen eine Mittenposition C1 in Richtung einer Achsenlinie O, eine Position C2 bei 90° in Umfangsrichtung ausgehend von der Mittenposition C1, eine Position C3 bei 270° in Umfangsrichtung ausgehend von der Mittenposition C1 und die Positionen C4 und C5 bei 50 mm entfernt von den Endpositionen auf der Maßhilfslinie der Mittenposition C1 entlang der Achsenlinie O sind.

**3.** Sputtertarget gemäß Anspruch 2,
wobei die Ca-Konzentrationsverteilung in der Ebene $D_{Ca}=(\sigma_{Ca}/\mu_{Ca})\times100$ [%] 40 % oder weniger beträgt und die Ca-Konzentrationsverteilung in der Ebene $D_{Ca}$ durch einen Durchschnittswert $\mu_{Ca}$ von Ca-Konzentrationsanalysewerten, die durch Analysieren der Ca-Konzentrationen an fünf Stellen auf der Sputteroberfläche wie in Anspruch 2 definiert erhalten werden, und durch eine Standardabweichung $\sigma_{Ca}$ der Ca-Konzentrationsanalysewerte definiert ist.

## Revendications

**1.** Film d'alliage d'argent ayant une composition comprenant :

In : 0,1 % en masse à 1,5 % en masse ;
Cu : 1 ppm en masse à 50 ppm en masse ;
Ca : 0,5 ppm en masse à 20 ppm en masse ; et
optionnellement Sb : 0,01 % en masse à 1,0 % en masse, le reste étant de l'Ag et des impuretés inévitables.

**2.** Cible de pulvérisation planaire et rectangulaire ou cylindrique pour la formation du film d'alliage d'Ag selon la revendication 1, la cible de pulvérisation ayant une composition comprenant :

In : 0,1 % en masse à 1,5 % en masse ;
Cu : 1 ppm en masse à 50 ppm en masse ;
Ca : 0,5 ppm en masse à 20 ppm en masse ; et
optionnellement Sb : 0,1 % en masse à 3,5 % en masse, le reste étant de l'Ag et des impuretés inévitables,
dans laquelle une concentration d'oxygène dans la cible de pulvérisation est inférieure à 50 ppm en masse, une zone d'une surface de pulvérisation est de 0,25 m$^2$ ou plus, et
une distribution de concentration de cuivre en longitude $D_{Cu} = (\sigma_{Cu}/\mu_{Cu})$ x 100 [%] est de 40 % ou moins, et la distribution de concentration de Cu en longitude $D_{Cu}$ est définie par une valeur moyenne, $\mu_{Cu}$ des valeurs d'analyse de concentration de cuivre obtenues en analysant des concentrations de cuivre au niveau de cinq points sur la surface de pulvérisation (11), et par une déviation standard, $\sigma_{Cu}$ des valeurs d'analyse de concentration de cuivre, dans laquelle dans la cible de pulvérisation planaire et rectangulaire les cinq points sont une position centrale C1 de la surface de pulvérisation (11) et des positions C2, C3, C4 et C5 à 50 mm des coins dans un sens central le long des lignes de diagonale, et dans la cible de pulvérisation cylindrique les cinq points sont une position centrale C1 dans le sens d'une ligne d'axe O, une position C2 à 90° dans le sens circonférentiel à partir de la position centrale C1, une position C3 à 270° dans le sens circonférentiel à partir de la position centrale C1, et des positions C4 et C5 à 50 mm des parties d'extrémité sur la ligne d'extension de la partie centrale C1 le long de la ligne d'axe O.

**3.** Cible de pulvérisation selon la revendication 2,
dans laquelle une distribution de concentration de Ca en longitude $D_{Ca} = (\sigma_{Ca}/\mu_{Ca})$ x 100 [%] est de 40 % ou moins, et la distribution de concentration de Ca en longitude $D_{Ca}$ est définie par une valeur moyenne, $\mu_{Ca}$ des valeurs d'analyse de concentration de Ca obtenues en analysant des concentrations de Ca au niveau de cinq points sur la surface de pulvérisation selon la revendication 2, et par une déviation standard, $\sigma_{Ca}$ des valeurs d'analyse de concentration de Ca.

FIG. 1

(a)

10A(10)

C5

C2

C1

11

C4

C3

(b)

11

10A(10)

# FIG. 2

(a)

(b)

FIG. 3

FIG. 4

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2014080354 A
- JP 2006245230 A
- JP 2012059576 A
- JP 2009031705 A
- JP 2013216976 A
- JP 2013165053 A
- JP 2014019932 A
- JP 2015100604 A